# EUROPEAN PATENT SPECIFICATION

(11) **EP 2 157 621 B1**
(45) Date of publication and mention of the grant of the patent: **04.10.2017**
(21) Application number: 09168254.2
(22) Date of filing: 20.08.2009
(51) Int. Cl.: H01L 31/056, H01L 31/074, H01L 31/18, H01L 31/0392

(54) **Heterojunction solar cell and process for manufacturing the same**
Heteroübergangssolarzelle und Verfahren zu deren Herstellung
Cellule solaire à hétérojonction et son procédé de fabrication

(30) Priority: 22.08.2008 JP 2008214577
(43) Date of publication of application: 24.02.2010
(73) Proprietor: Shin-Etsu Chemical Co., Ltd., Chiyoda-ku, Tokyo (JP)
(72) Inventor: Ito, Atsuo, ANNAKA-SHI Gunma (JP); Akiyama, Shoji, ANNAKA-SHI Gunma (JP); Kawai, Makoto, ANNAKA-SHI Gunma (JP); Tanaka, Kouichi, ANNAKA-SHI Gunma (JP); Tobisaka, Yuji, ANNAKA-SHI Gunma (JP); Kubota, Yoshihiro, ANNAKA-SHI Gunma (JP)
(74) Representative: Vidon Brevets & Stratégie

(56) References cited:
- EP-A2- 1 921 683
- WO-A2-2008/082723
- JP-A- 57 103 371
- JP-A- 2003 017 723
- US-A- 3 679 949
- A. K. GHOSH ET AL: "SnO2/Si solar cells-heterostructure or Schottky-barrier or MIS-type device", JOURNAL OF APPLIED PHYSICS, vol. 49, no. 6, 1 January 1978 (1978-01-01), page 3490, XP55042257, ISSN: 0021-8979, DOI: 10.1063/1.325260
- TOM FENG ET AL: "Efficient electron-beam-deposited ITO/n-Si solar cells", JOURNAL OF APPLIED PHYSICS, vol. 50, no. 7, 1 January 1979 (1979-01-01), page 4972, XP55042220, ISSN: 0021-8979, DOI: 10.1063/1.325574

## Description

### BACKGROUND OF THE INVENTION

### 1. Field of the Invention

The present invention relates to a heterojunction solar cell and the process for manufacturing the same, particularly relates to a heterojunction solar cell comprising a photoconversion layer on a metal substrate and the process for manufacturing the same.

### 2. Description of the Related Art

Solar cells composed mainly of silicon are classified, according to their crystallinity, into single-crystal silicon solar cells, polycrystalline silicon solar cells, and amorphous silicon solar cells. Among these, single-crystal silicon solar cells are manufactured by the following steps: using crystal pulling to obtain a single crystal ingot; cutting the ingot in the form of wafers with a wire saw; processing the wafers into 100 to 200 µm-thick wafers; and forming p-n junctions, electrodes, protective films, and the like on the wafers.

Polycrystalline silicon solar cells are manufactured by manufacturing a polycrystalline ingot not by crystal pulling but by crystallizing molten metal silicon in a mold, then slicing the ingot into wafers with a wire saw, processing the wafers into 100 to 200 µm-thick wafers, and forming p-n junctions, electrodes, protective films, and the like on the wafers in the same way as single-crystal silicon solar cells.

Amorphous silicon solar cells are manufactured by the steps of: using, for example, plasma CVD to decompose a silane gas by discharge in the gas phase to form an amorphous hydrogenated silicone film on a substrate; doping the film with a doping gas such as diborane or phosphine to the film while depositing the gas on the film to form a p-n junction and a film simultaneously; and subsequently forming an electrodes and a protective film. Amorphous silicon solar cells have an advantage over crystalline silicon solar cells in that the thickness of an amorphous silicon layer can be reduced to about 1 µm, about hundredth part of that of a crystalline silicon layer. This results from the fact that the optical absorption coefficient of amorphous silicon is about an order of magnitude higher than the optical absorption coefficients of single-crystal and polycrystalline silicon because amorphous silicon absorbs incident light as a direct-transition semiconductor (Kiyoshi Takahashi, Yoshihiro Hamakawa and Akio Ushirokawa, "Taiyoko Hatsuden (Photovoltaic Power Generation)", Maruzen, 1980, page 233). The annual production of solar cells has recently exceeded 1 GW worldwide and is expected to increase further in future, so great expectations are placed on thin-film amorphous silicon solar cells that can make effective use of resources.

The production of amorphous silicon solar cells requires a high-purity gas raw material of e.g. silane or disilane, and some of the raw material is deposited on places other than the substrate in a plasma CVD apparatus. Therefore, which of amorphous and crystalline silicon solar cells use more effectively resources cannot be determined by simply comparing the film thickness necessary for amorphous silicon solar cells with that for crystalline solar cells. In addition, amorphous silicon solar cells has a conversion efficiency of about 10% whereas crystalline solar cells has a conversion efficiency of about 15%, and moreover, amorphous silicon solar cells have another problem that remains to be solved because their output characteristics decrease when they are irradiated with light.

On the other hand, attempts have been made to use crystalline silicone materials for developing thin-film solar cells (Kiyoshi Takahashi, Yoshihiro Hamakawa, and Akio Ushirokawa, "Taiyoko Hatsuden (Photovoltaic Power Generation)", Maruzen, 1980, page 217). An example of these attempts is to deposit a polycrystalline thin film on a substrate such as an alumina substrate or a graphite substrate with a gas such as trichlorosilane gas or tetrachlorosilane gas. This deposited film has many crystal defects and thus a low conversion efficiency if left untreated, so its light trapping structure needs to be improved for higher conversion efficiency by zone melting as described in JP 2004-342909 A. However, a problem of crystalline silicone solar cells is that even such zone melting does not prevent a leakage current at the grain boundary and a shorter lifetime from reducing the photocurrent response characteristics in the long wavelength region.
A heterojunction solar cell and process for manufacturing the same is known from JP2003/017723. A method for producing single crystal silicon solar cell and single crystal silicon solar cell is also known from EP1921683. JP57103371 describes a method for producing a heterojunction solar cell comprising an n-type transparent semiconductor formed on an n-type Si substrate or a thin Si film formed an another substrate.

### SUMMARY OF THE INVENTION

The present invention has been made in view of the problems above, and an object thereof is to provide a thin-film heterojunction solar cell comprising a photoconversion layer that has excellent conversion characteristics and that is degraded less by light irradiation, where a single-crystal silicon layer constituting the photoconversion layer of the silicone solar cell is made thin to make effective use of silicon as a raw material of the silicone solar cell, as a solar cell having a light trapping structure made as efficient as possible for film thickness, and to provide a process for manufacturing the thin-film heterojunction solar cell.

To achieve the object above, the present invention provides a process for manufacturing a heterojunction solar cell, according to claim 1, comprising at least a metal substrate, an n-type single-crystal silicon layer, an n-type transparent semiconductor layer, and a transparent protective film that are laminated together and serving the transparent protective film side as a light-receiving surface, said process comprising at least the steps of:
providing the metal substrate and the n-type single-crystal silicon substrate;
implanting at least one of a hydrogen ion and a noble gas ion in the n-type single-crystal silicon substrate to form an ion-implanted layer;
adhering an ion-implanted surface of the n-type single-crystal silicon substrate to the metal substrate via an electroconductive adhesive;
curing the electroconductive adhesive to form an electroconductive adhesion layer so that the n-type single-crystal silicon substrate and the metal substrate can laminate together;
giving an impact to the ion-implanted layer to mechanically and partially delaminate the n-type single-crystal silicon substrate so as to form the n-type single-crystal silicon layer;
depositing the n-type transparent semiconductor layer on the n-type single-crystal silicon layer;
forming an collecting electrode on a part of the n-type transparent semiconductor layer; and
forming the transparent protective film on both the n-type transparent semiconductor layer and the collecting electrode;
wherein the electroconductive adhesion layer comprises a transparent electroconductive material, and comprises light scattering particles having a high refractive index or has microscopic voids for light scattering; and wherein a material of the light scattering particles having a high refractive index is selected from the group consisting of a molybdenum oxide, and a hafnium oxide.

According to the process for manufacturing a heterojunction solar cell not being a part of the present invention but representing a background art that is useful for understanding the invention a heterojunction solar cell having a light trapping structure can be manufactured that has a thin-film n-type single-crystal silicon layer and an n-type transparent semiconductor layer which together constitute a photoconversion layer as well as a metal light-reflecting layer on the side opposite to a light-receiving surface. The photoconversion layer of the heterojunction solar cell not being a part of the present invention but representing a background art that is useful for understanding the invention may be composed of an n-type single-crystal silicon layer and an n-type transparent semiconductor layers deposited on the n-type single-crystal silicon layer. Therefore, this solar cell has a high conversion efficiency for the film thickness of the single-crystal silicon layer and is degraded less by light irradiation.

Moreover, according to the process for manufacturing a single-crystal silicon solar cell comprising these steps, the n-type single-crystal silicon layer constituting the photoconversion layer is formed by delamination of the single-crystal silicon substrate, which can improve the crystallinity of the n-type single-crystal silicon layer. This improved crystallinity can further improve the conversion efficiency of a solar cell.

In addition, the single-crystal silicon substrate and the metal substrate are laminated together by curing an electroconductive adhesive, which can strongly join both substrates. The strongly-joined bonding surfaces allows the subsequent mechanical and partial delamination of the n-type single-crystal silicon substrate by giving an impact to the ion-implanted layer, thereby forming a thin n-type single-crystal silicon layer on the metal substrate via an electroconductive adhesion layer. Therefore, the n-type single-crystal silicon layer can be made thin without heat treatment for delamination.

In addition, the n-type single-crystal silicon substrate is delaminated not thermally but mechanically to form an n-type single-crystal silicon layer, which may prevent cracks and defects due to the difference in the coefficient of thermal expansion from being introduced in the n-type single-crystal silicon layer constituting the photoconversion layer.

In addition, a thin-film solar cell having a thin silicon layer can save on a silicon raw material and make effective use thereof.

In addition, a metal substrate in the form of a thin film not being a part of the present invention but representing a background art that is useful for understanding the invention can provide a solar cell that can be expanded in the form of a curved surface and folded in the form of a roll and as needed unfolded for use. The metal substrate can comprise one of aluminum, titanium, tungsten, chromium and nickel. If a metal substrate comprises one of aluminum, titanium, tungsten, chromium and nickel as mentioned above, then a light trapping structure can easily be manufactured where visible light passing through the thin-film n-type single-crystal silicone layer is reflected at the metal substrate interface at a high reflectance and absorbed again by the thin-film n-type single-crystal silicon layer for photoelectric conversion.

In addition, preferably, the n-type transparent semiconductor layer comprises at least one of a titanium oxide, a zinc oxide, a tin oxide and an indium oxide as transparent semiconductor(s) and comprises a donor-forming dopant material for donor formation in the transparent semiconductor(s).

The n-type transparent semiconductor layer used in the process for manufacturing a heterojunction solar cell according to the present invention, may comprise at least one of a titanium oxide, a zinc oxide, a tin oxide and an indium oxide as transparent semiconductor(s) as mentioned above and further comprise a donor-forming dopant material for donor formation in the transparent semiconductor(s).

In addition, the electroconductive adhesive may preferably comprise at least one of a silicone resin, an epoxy resin, an acrylic resin, an alicyclic acrylic resin, a liquid crystal polymer, a polycarbonate and a polyethylene terephthalate. If an electroconductive adhesive comprises at least one of a silicone resin, an epoxy resin, an acrylic resin, an alicyclic acrylic resin, a liquid crystal polymer, a polycarbonate and a polyethylene terephthalate as mentioned above, visible light rays can pass through the electroconductive adhesion layer and can be reflected on the metal substrate and introduced back again into the n-type single-crystal silicon layer and the n-type transparent semiconductor layer that together constitute the photoconversion layer, which may further improve the conversion efficiency of the solar cell manufactured.

In addition, a depth from the ion-implanted surface to the ion implanted layer may be preferably from 2 µm to 50 µm. If the ion implantation depth is preferably from 2 µm to 50 µm beneath the ion-implanted surface as mentioned above, then the thickness of the n-type single-crystal silicon layer constituting the photoconversion layer of the heterojunction solar cell manufactured can be set at about between 2 µm or more and 50 µm or less. Moreover, a heterojunction solar cell having a thin-film n-type single-crystal silicon layer of such a thickness can provide practical conversion efficiency for a heterojunction solar cell having a thin-film single-crystal silicon layer and save on the amount of silicon raw material used.

In addition, the transparent protective film may preferably have a light-scattering property. If the transparent protective film has the light-scattering property as mentioned above, then this film can further elongate the optical path length of light entering the n-type single-crystal silicon layer constituting the photoconversion layer. This enables to produce a heterojunction solar cell having a light trapping structure that allows more light to be absorbed by the n-type single-crystal silicon layer constituting the photoconversion layer. This can further increase the conversion efficiency of the solar cell.

In addition, the present invention may provide a heterojunction solar cell manufactured by any of the above processes for manufacturing a heterojunction solar cell. If a heterojunction solar cell is manufactured by any of the above processes for manufacturing a heterojunction solar cell as mentioned above, then the n-type single-crystal silicon layer constituting the photoconversion layer along with the n-type transparent semiconductor layer is formed by delamination of the single-crystal silicon substrate and the single-crystal silicon substrate is delaminated not thermally but mechanically, which enables the highly crystalline single-crystal silicon layer. Therefore, a thin-film solar cell having a high conversion efficiency for the film thickness can be manufactured. In addition, this solar cell is a solar cell whose single-crystal silicon layer has a thin thickness, so it can make effective use of a silicon raw material.

In addition, the present invention provides a heterojunction solar cell comprising at least a metal substrate, an electroconductive adhesion layer, an n-type single-crystal silicon layer, an n-type transparent semiconductor layer in this order, and further comprising a collecting electrode formed between the n-type single-crystal silicon layer and a transparent protective film are sequentially laminated together, wherein the electroconductive adhesion layer comprises a transparent electroconductive material, and comprises light scattering particles having a high refractive index or has macroscopic voids for light scattering, wherein a material of the light scattering particles having a high refractive index is selected from the group consisting of molybdenum oxide and a hafnium oxide. If a heterojunction solar cell comprises at least a metal substrate, an electroconductive adhesion layer, an n-type single-crystal silicon layer, an n-type transparent semiconductor layer in this order and further comprising a collecting electrode partially formed between the n-type single-crystal silicon layer and a transparent protective film as mentioned above, then this silicon solar cell whose photoconversion layer is provided on the metal substrate has the n-type transparent semiconductor layer and the n-type single-crystal silicon layer constituting the photoconversion layer, which enables a high conversion efficiency of solar cell for the film thickness of the single-crystal silicon layer.

In this case, the metal substrate preferably comprises one of aluminum, titanium, tungsten, chromium and nickel. If a metal substrate comprises one of aluminum, titanium, tungsten, chromium, and nickel as mentioned above, then a light trapping structure can easily be manufactured where visible light passing through the thin-film n-type single-crystal silicon layer is reflected on the metal substrate interface at a high reflectance and absorbed again by the thin-film n-type single-crystal silicon layer for photoelectric conversion.

In addition, preferably, the n-type transparent semiconductor layer comprises at least one of a titanium oxide, a zinc oxide, a tin oxide, and an indium oxide as transparent semiconductor(s) and comprises a donor-forming dopant material for donor formation in the transparent semiconductor(s).

As the n-type transparent semiconductor layer, for example, one comprising at least one of a titanium oxide, a zinc oxide, a tin oxide, and an indium oxide as transparent semiconductor(s) and comprising a donor-forming dopant material for donor formation in the transparent semiconductor(s) as mentioned above can preferably be used.

In addition, the electroconductive adhesion layer preferably comprises at least one of a silicone resin, an epoxy resin, an acrylic resin, an alicyclic acrylic resin, a liquid crystal polymer, a polycarbonate and a polyethylene terephthalate. If an electroconductive adhesion layer comprises at least one of a silicone resin, an epoxy resin, an acrylic resin, an alicyclic acrylic resin, a liquid crystal polymer, a polycarbonate and a polyethylene terephthalate as mentioned above, then light passing through the electroconductive adhesion layer because of the excellent visible light transmittance of the materials above can be reflected on the metal substrate and introduced again into the n-type single-crystal silicon layer and the n-type transparent semiconductor layer constituting the photoconversion layer, which enables the further improvement of the conversion efficiency of the solar cell.

In addition, the n-type single-crystal silicon layer preferably has a thickness of from 2 µm to 50 µm. If an n-type single-crystal silicon layer has a thickness of from 2 µm to 50 µm as mentioned above, then such a thickness can provide a practical conversion efficiency as a heterojunction solar cell having a thin-film single-crystal silicon layer constituting the photoconversion layer and save on the amount of silicone raw material used.

In addition, the transparent protective film preferably has a light-scattering property. If a transparent protective film has a light-scattering property as mentioned above, then this film can further elongate the optical path length of light entering the n-type single-crystal silicon layer constituting the photoconversion layer. This enables to produce a heterojunction solar cell having a light trapping structure that allows more light to be absorbed by the n-type single-crystal silicon layer constituting the photoconversion layer. This can further increase the conversion efficiency of the solar cell.

If a process for manufacturing a heterojunction solar cell is according to the present invention, a light trapping-type thin-film heterojunction solar cell can be manufactured where a photoconversion layer having a high conversion efficiency that is composed of a n-type single-crystal silicon layer having a good crystallinity and an n-type transparent semiconductor layer is provided on a metal substrate.

In addition, a heterojunction solar cell according to the present invention is a light trapping-type thin-film solar cell where a single-crystal silicon layer having a good crystallinity and a high conversion efficiency is provided on a metal substrate as a photoconversion layer, which provides a solar cell having a high conversion efficiency for the film thickness.

### BRIEF DESCRIPTION OF THE DRAWINGS

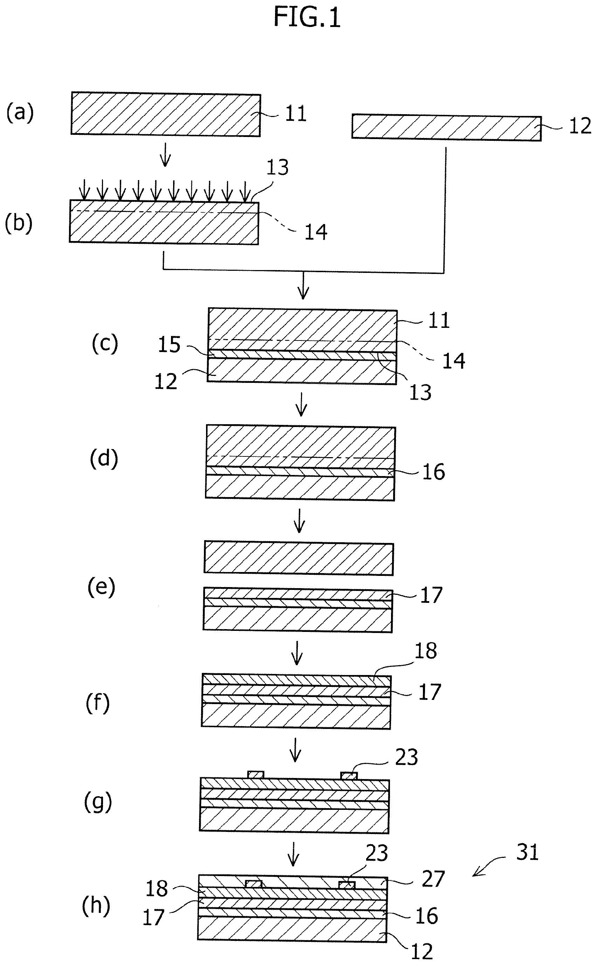

FIG. 1 is a flow sheet showing one embodiment of the process for manufacturing a heterojunction solar cell according to the present invention.

### DETAILED DESCRIPTION OF THE PREFERRED EMBODIMENT(S)

As described above, even a thin-film solar cell capable of saving a silicon raw material is required to have still higher conversion efficiency. For this reason, such a solar cell needs to use a crystalline silicon, and the crystallinity of the silicon is also required to be improved.

Under these circumstances, the present inventors have studied the issue above and found that the lamination of a n-type single-crystal silicon substrate and a metal substrate followed by reducing the thickness of the n-type single-crystal silicon substrate may increase the crystallinity of the silicon layer constituting the photoconversion layer and that an n-type transparent semiconductor layer can be formed on an n-type single-crystal silicon layer formed by thin film preparation to obtain a heterojunction solar cell. Moreover, the inventors have found that the n-type single-crystal silicon substrate may be strongly adhered without heat treatment to the metal substrate by interposing an electroconductive adhesive and curing the same. The inventors also have found that the mechanical delamination may eliminate the need for high-temperature heat treatment so that the crystallinity of the n-type single-crystal silicon layer may be maintained. These findings have the inventors to complete the present invention.

Hereinafter, several embodiments of the present invention will be described specifically, but the present invention is not limited thereto.

FIG. 1 is a flow sheet showing one embodiment of the process of the preset invention for manufacturing a heterojunction solar cell.

First, an n-type single-crystal silicon substrate 11 and a metal substrate 12 are provided (step a). The n-type single-crystal silicon substrate 11 is not particularly limited as long as its conductivity type is n-type, and for example, a substrate obtained by slicing a single crystal grown by the Czochralski process can be used. The substrate may have a diameter of 100 to 300 mm and a resistivity of about 0.1 to 20 Ω·cm.

The metal substrate 12 is not particularly limited, but various metal substrates can be selected. The metal substrates may preferably have a high reflectance for visible light, more preferably have a reflectance of 60% or more for visible light. For example, metal substrates may comprise one of aluminum, titanium, tungsten, chromium and nickel. Specifically, stainless steel (e.g., SUS304) or the like can be used. Other usable metal substrates may comprise: an aluminum substrate; and a stainless steel substrate on which silver is deposited (silver-deposited stainless steel substrate). Such a metal substrate reflects visible light at a high reflectance, so a solar cell having a higher efficiency can be manufactured. In addition, a flexible substrate in the form of a thin plate can also be used for this metal substrate to obtain a solar cell that can be placed on a curved surface. In this sense, metal substrates as mentioned above are preferable and a stainless steel substrate is particularly preferable.

Next, at least one of hydrogen ions and noble gas ions is implanted in the n-type single-crystal silicon substrate 11 to form an ion-implanted layer 14 (step b).

For example, the temperature of the n-type single-crystal silicon substrate is set at 200 to 350°C and at least one of hydrogen ions and noble gas ions is implanted therein in specified doses with an implantation energy that can form the ion-implanted layer 14 at a depth corresponding to the desired thickness of the single-crystal silicon layer, such as at a depth of 0.1 to 5 µm or less, below a substrate surface 13. In this case, the hydrogen ions are particularly preferable because they are so light that it is implanted deeper below the ion-implanted surface 13 with the same acceleration energy.

The hydrogen ions may have a positive or negative charge and may be atomic ions or hydrogen gas ions. The noble gas ions may also have a positive or negative charge.

In addition, after an insulating film such as a thin silicon dioxide film is formed in advance on the surface of the n-type single-crystal silicon substrate, ion implantation through the film is effective in preventing the channeling effect of the implanted ions.

Next, with the ion-implanted surface 13 as a lamination surface, the n-type single-crystal silicon substrate 11 is adhered to the metal substrate 12 via an electroconductive adhesive 15 (step c). Examples of the electroconductive adhesive include an electroconductive material comprising a titanium oxide, a zinc oxide, a tin oxide, an indium oxide, or the like as well as comprising a dopant material to increase the electrical conductivity of these materials. Generally as dopant materials, an indium oxide is doped with tin to form the so-called indium tin oxide (tin-doped indium oxide; ITO), a tin oxide is doped with fluorine or antimony, a zinc oxide is doped with gallium or aluminum, but the dopant materials are not limited thereto and are appropriately designed. Moreover, this electroconductive adhesive is preferably a resin having excellent visible light transmission, such as a resin comprising at least one of a silicone resin, an epoxy resin, an acrylic resin, an alicyclic acrylic resin, a liquid crystal polymer, a polycarbonate, and a polyethylene terephthalate, that comprises particles of the transparent, electroconductive material as a filler. The use of an organic electroconductive polymer such as polyethylene dioxythiophene-polystyrene sulfonate (PEDOT/PSS) can also be selected. Moreover, in addition to particles of the transparent, electroconductive material above, nanoparticles of carbon or silver can also be selected as a filler of a transparent, electroconductive material, and in this case, an adhesive comprising these nanoparticles has a relatively low transparency. The electroconductive adhesive used is not limited thereto and preferably has a surface resistivity of 100 Ω/sq. or less. Moreover, the adhesive preferably has a visible light transmissivity of 80% or more.

Then, the n-type single-crystal silicon substrate 11 is adhered to the metal substrate 12 via such an electroconductive adhesive 15. The surface to be adhered can be the ion-implanted surface 13 of the n-type single-crystal silicon substrate. Specifically, a thin film of an electroconductive adhesive can be formed on at least one surface to be adhered of the n-type single-crystal silicon substrate and the metal substrate. As a method of forming this thin film of an electroconductive adhesive, a coating method such as slit die coating or dip coating can be selected. Then, the n-type single-crystal silicon substrate is adhered to the metal substrate via this thin film of an electroconductive adhesive.

Next, the electroconductive adhesive 15 is cured into an electroconductive adhesion layer 16 in order to laminate the n-type single-crystal silicon substrate 11 and the metal substrate 12 together (step d). The method of curing the electroconductive adhesive is not particularly limited, and varies depending on the material used. In one embodiment, the n-type single-crystal silicon substrate and the metal substrate may be strongly laminated together by curing the electroconductive adhesive by a method such as a method of once heating the electroconductive adhesive to about 250°C for softening and then cooling the adhesive or a method of volatilizing a solvent. Note, however, that this curing treatment may be performed at room temperature to about 250°C, and heat treatment at 350°C or more may be not performed. This is because if heat treatment at a temperature as high as 350°C or more is performed with the n-type single-crystal silicon substrate 11 and the metal substrate 12 laminated together, the difference in the coefficient of thermal expansion between the two may cause thermal strain, cracks, delamination, and the like to occur in the n-type single-crystal silicon substrate 11. Such heat treatment at a temperature as high as 350°C or more is not performed until the delamination of the n-type single-crystal silicon substrate 11 to transfer the n-type single-crystal silicon layer of step e described later are complete.

Next, an impact is given to the ion-implanted layer 14 to mechanically and partially delaminate the n-type single-crystal silicon substrate 11 to leave an n-type single-crystal silicon layer 17 (step e). In the present invention, none of thermal strain, cracks, delamination, or the like due to heating occurs because an impact is given to the ion-implanted layer for mechanical separation. In order to give an impact to the ion-implanted layer, a jet of a fluid such as a gas or a liquid may be applied to a circumferential surface of the joined wafer continuously or intermittently, and the method of giving an impact is not particularly limited as long as the impact causes mechanical delamination.

Here, when the n-type single-crystal silicon substrate is mechanically and partially delaminated, a supporting substrate is desirably adhered to at least the back of the metal substrate. Such mechanical delamination using the supporting substrate can prevent minor cracks due to warpage and crystal defects caused by the cracks from occurring in the single-crystal silicon layer 17 transferred by delamination, thereby preventing a decrease in solar cell conversion efficiency. If both substrates have a thickness as thin as about 1 mm or less, they benefit significantly from this method.

In addition, after delamination transferring of the n-type single-crystal silicon substrate, heat treatment may be performed to recover damage caused by ion implantation near the surface of the n-type single-crystal silicon layer 17. The n-type single-crystal silicon substrate 11 has already been delaminated to leave a thin film of the n-type single-crystal silicon layer 17. Therefore, even local heat treatment near the surface at 350°C or more suffers almost no new cracks or defects caused thereby. In addition, this is the same even in the subsequent steps.

Next, an n-type transparent semiconductor layer 18 is deposited on the n-type single-crystal silicon layer 17 (step f). This n-type transparent semiconductor layer 17 comprises at least one of a titanium oxide, a zinc oxide, a tin oxide and an indium oxide as transparent semiconductor(s), and preferably comprise(s) a donor-forming dopant material for donor formation in the transparent semiconductor(s) above. Specific examples thereof include an indium oxide doped with tin, which is an indium tin oxide (ITO), a tin oxide doped with fluorine or antimony, and a titanium oxide doped with niobium. Sometimes these are generally called transparent, electroconductive films, and from another point of view, are semiconductors having a wide band gap (i.e., that has a high visible light transmissivity and is transparent). Here, as used herein, the term "transparent" used for the n-type transparent semiconductor layer means having a high transparency to visible light, not to ultraviolet light. This n-type transparent semiconductor layer 18 can be formed by a method such as chemical sputtering or chemical deposition at a temperature as low as 300°C or less, while the condition may vary depending on the material used.

In addition, the film thickness of this n-type transparent semiconductor layer 18 is not particularly limited, but can be, for example, from 1 µm to 100 µm. Particularly, if a solar cell is manufactured as a flexible thin-film solar cell, the n-type transparent semiconductor layer 18 is desirably made thinner, and is preferably a thickness of 50 µm or less, for example.

Next, an electrode 23 is formed on the surface of the n-type single-crystal silicon layer 17 that faces the second electroconductive silicon layer 22 (step g). A linear electrode is formed on a diffusion-treated surface by a method such as vacuum deposition or chemical sputtering with a metal or a transparent, electroconductive material to form an electrode 23 that is a counter electrode of an electroconductive adhesion layer 16 as an electrode. Moreover, a collecting electrode can also be formed by printing with an electroconductive paste comprising a metal. This collecting electrode-forming composition can be cured by flash-lamp annealing or infrared heating.

In addition, a transparent protective film 27 is formed on the n-type transparent semiconductor layer 18 on which the collecting electrode 23 is partially formed (step h). Here, the material of the transparent protective film 27 is not particularly limited, but desirably has a high visible light transmissivity. Examples thereof include silicon oxides, silicon nitrides and aluminum oxides. In addition, the method of forming the transparent protective film 27 is also not particularly limited. For example, if the material is a silicon oxide, a silicon nitride, or an aluminum oxide, the transparent protective film 27 can be formed by one of various CVD methods or a deposition method such as reactive sputtering.

Moreover, the n-type single-crystal silicon substrate delaminated to transfer the n-type single-crystal silicon layer 17 in step e can be recycled as the n-type single-crystal silicon substrate 11 by subjecting the rough surface and the ion-implanted layer after delamination to smoothing and removal treatment by grinding followed by repeated ion implantation treatment. In the process for manufacturing a single-crystal silicon solar cell according to the present invention, the n-type single-crystal silicon substrate does not need to be heated to 350°C or more in the ion implantation step to the delamination step, so oxygen-induced defects are very unlikely to be made into the single-crystal silicon substrate. For this reason, if a nearly 1 mm-thick n-type single-crystal silicon substrate is originally used and the film thickness of the n-type single-crystal silicon layer 17 is 5 µm, then the substrate can be delaminated for transfer 100 times or more.

In order to increase the conversion efficiency, a solar cell is designed to have a structure that causes light scattering at both a side of which light enters and the backside on which the light is reflected. Such light scattering structures can be designed, for example by imparting the light-scattering property to the transparent protective film 27 and the electroconductive adhesion layer 15.

The electroconductive adhesion layer 15 comprises light scattering particles having a high refractive index or have microscopic voids to scatter incident light on the back side of the single-crystal silicon layer during solar cell operation, thereby further elongating the optical path length of light entering the single-crystal silicon layer. This enables to produce a light trapping structure that allows more light to be absorbed by the single-crystal silicon layer. This can increase the conversion efficiency of the solar cell. Here, desirably, light scattering particles have a particle size of about 0.1 µm or more and microscopic voids have a size of about 0.1 µm or more. A molybdenum oxide, or a hafnium oxide are selected as a material of light-scattering fine particles having a high refractive index.

In addition, similarly, a structure comprising microscopic transparent particles having a particle size of about 0.1 µm or more and having refractive indices different from each other or comprising microscopic voids in the transparent protective film 27 can be created to impart light-scattering property to the transparent protective film 27.

However, the transparent protective film 27 and the electroconductive adhesion layer 15 do not need to have light-scattering property over the entire region thereof and may have light-scattering property on a part of the region. For example, the transparent protective film 27 can have a rough surface having bumpy portions of no less than about 0.1 µm in order to impart light-scattering property to the film.

Here, various methods of forming the above structure that causes light scattering can be used in combination.

A heterojunction solar cell 31 manufactured by such a production process has a metal substrate 12, an electroconductive adhesion layer 16, an n-type single-crystal silicon layer 17, an n-type transparent semiconductor layer 18, and an electrode 23 that are sequentially laminated together. None of thermal strain, delamination, cracks, and the like occur in the n-type single-crystal silicon layer 17 and this layer is thin and has a good film thickness uniformity and excellent crystallinity.

In the solar cell 31 having such a structure, incident light from the transparent protective film 27 side is absorbed mainly by the n-type single-crystal silicon layer and charge is separated in the heterojunction interface region between the n-type single-crystal silicon layer and the n-type transparent semiconductor layer to allow the metal substrate 12 side and the electrode 23 to extract electric power.

In addition, the heterojunction solar cell 31 has the metal substrate 12 on the side opposite to the transparent protective film 27 side, so even when part of incident light from the transparent protective film 27 is not absorbed by the single-crystal silicon layer 17 and passes through the single-crystal silicon layer, the transmitted light can be reflected by the metal substrate 12 and passed back again through the single-crystal silicon layer 17 to increase the optical absorptance on the whole. Especially, if the metal substrate has a visible light reflectance of 60% or more as for example a stainless steel (e.g., SUS304) substrate, an aluminum substrate, or a silver-deposited stainless steel substrate, then a solar cell can be created where visible light passing through the thin-film single-crystal silicon layer is reflected on the metal substrate interface with high efficiency and is absorbed again by the thin-film single-crystal silicon layer followed by photoelectric conversion. In a thin-film heterojunction solar cell made very thin by using a single-crystal silicon layer having a much lower optical absorptance than an amorphous silicon layer as the photoconversion layer, so-called a light trapping structure such as this back reflector (metal substrate) is effective in increasing the conversion efficiency.

In this case, the electroconductive adhesion layer 15 is particularly desirably made of a material having a high transparency, and usually, the electroconductive adhesion layer 15 is so thin that light can pass through the layer even if the layer is made of a material having a high opacity.

Moreover, if a method as described above is used to impart light-scattering property to the transparent protective film 27 or to the electroconductive adhesion layer 15, then the scattering of light can further elongate the optical path length of light entering the single-crystal silicon layer 17. This enables to produce a light trapping structure that allows more light to be absorbed by the single-crystal silicon layer 17. This structure can increase the conversion efficiency of a solar cell.

In addition, a flexible substrate in the form of a thin film or thin plate can be used as the metal substrate to create a solar cell that can be expanded in the form of a curved surface and folded in the form of a roll and as needed unfolded for use.

In addition, if a method as described above is used to create a heterojunction solar cell where the single-crystal silicon layer 17 has a thickness between 2 µm or more and 50 µm or less, then the solar cell can provide practical efficiency as a thin-film heterojunction solar cell and sufficiently save on the amount of silicon raw material used.

The present invention will be described below more specifically by referring to an Example and a Comparative Example, and the present invention is not limited thereto.

### (Example)

An n-type single-crystal silicon substrate having a diameter of 200 mm (8 inches), crystal face (100), and a surface resistance of 50 Ωcm was obtained as the n-type single-crystal silicon substrate 11. In addition, a stainless steel (SUS304) substrate having a thickness of 200 µm and a diameter of 200 mm was manufactured as the metal substrate 12 (step a).

Next, positive hydrogen ions were implanted into the n-type single-crystal silicon substrate 11 at an acceleration voltage of 350 keV at a dose of 1.0 × 10¹⁷/cm² (step b). The depth of an ion-implanted layer 14 was about 3 µm below the ion-implanted surface 13.

Next, a coating of a tin oxide doped with antimony was formed on the stainless steel substrate 12 by spraying. Electroconductive particles having an average particle size of 1.0 µm were made of an indium tin oxide. An electroconductive material was prepared so that it comprises 80% by weight of the electroconductive particles as a filler in a polycondensate obtained by hydrolysis of alkoxysilane and tetraalkoxysilane. This material was dissolved in an isopropyl alcohol solvent to obtain an electroconductive adhesive for the coating. The single-crystal silicon substrate 11 was adhered to the stainless steel substrate 12 via this electroconductive adhesive 15 (step c).

The laminated substrate was subjected to heat treatment at 250°C for 2 hours and then cooled to room temperature to cure the electroconductive adhesive 15 into the electroconductive adhesion layer 16 so as to securely bond the n-type single-crystal silicon substrate 11 with the stainless steel substrate 12 (step d).

Next, a high-pressure nitrogen gas was blown near the bond interface, and then the single-crystal silicon substrate was mechanically and partially delaminated as if torn off so that the delamination began at the blowing surface (step e). At this time, the single-crystal silicon substrate was allowed to adsorb a supporting substrate from the back before delamination. In addition, the single-crystal silicon layer transferred by delamination was irradiated with light by flash-lamp annealing under such a condition that the surface instantaneously reached 100°C or more to recover the damage caused by hydrogen implantation.

An thin film of an indium tin oxide having a thickness of 1 µm was formed as the thin-film n-type transparent semiconductor 18 on the surface of the n-type single-crystal silicon layer 17 by chemical sputtering at 300°C in an oxidizing atmosphere (step f).

Next, a silver electrode 23 was formed by vacuum deposition and patterning (step g). Thereafter, further a silver collecting electrode pattern 23 was formed by vacuum deposition using a metal mask. Then, a transparent protective film 27 made of nitrogen silicon was formed on the surface excluding the extraction electrode portion by reactive sputtering (step h).

As described above, a metal substrate, an electroconductive adhesion layer, a photoconversion layer involving heterojunction composed of an n-type single-crystal silicon layer and an n-type semiconductor layer, and an electrode were sequentially laminated together to produce a thin-film heterojunction solar cell 31.

The heterojunction solar cell manufactured in this way was irradiated with AM 1.5 light at 100 mW/cm² by using a solar simulator to determine the conversion efficiency. The conversion efficiency was 12 % and remained unchanged over time.

It should be understood that the present invention is not limited to the embodiment above. The embodiment above is merely exemplary of the present invention. Rather, the invention covers all modifications, equivalents, and alternatives falling within scope of the invention insofar as they have a configuration substantially equivalent to that described in the claims of the present invention and bring about similar advantageous effects to that of the present invention.

## Claims

1. A process for manufacturing a heterojunction solar cell (31) comprising a laminate comprising at least a metal substrate (12), an n-type single-crystal silicon layer (17), an n-type transparent semiconductor layer (18) and a transparent protective film (27), a surface of the transparent protective film (27) serving as a light-receiving surface, and the process comprising the steps of:
providing the metal substrate (12) and the n-type single-crystal silicon substrate (11);
implanting at least one of a hydrogen ion and a noble gas ion into the n-type single-crystal silicon substrate (11) so as to form an ion-implanted layer (14);
adhering an ion-implanted surface (13) of the n-type single-crystal silicon substrate (11) to the metal substrate (12) via an electroconductive adhesive (15);
curing the electroconductive adhesive (15) to form an electroconductive adhesion layer (16) so that the n-type single-crystal silicon substrate (11) and the metal substrate (12) can laminate together;
giving an impact to the ion-implanted layer (14) to mechanically and partially delaminate the n-type single-crystal silicon substrate (11) so as to leave an n-type single-crystal silicon layer (17) on the metal substrate (12);
depositing an n-type transparent semiconductor layer on the n-type single-crystal silicon layer (17);
forming a collecting electrode (23) on a part of the n-type transparent semiconductor layer (18);
forming a transparent protective film (27) on both the n-type transparent semiconductor layer (18) and the collecting electrode (23); and,
wherein the electroconductive adhesion layer (16) comprises transparent electroconductive material, and comprises light scattering particles having a high refractive index or has microscopic voids having a size of about 0.1 µm or more for light scattering; and wherein a material of the light scattering particles having a high refractive index is selected from the group consisting of a molybdenum oxide, and a hafnium oxide.

2. The process for manufacturing a heterojunction solar cell (13) according to claim 1, wherein the metal substrate (12) comprises at least one of aluminum, titanium, tungsten, chromium and nickel.

3. The process for manufacturing a heterojunction solar cell (31) according to claim 1 or 2, wherein the n-type transparent semiconductor layer (18) comprises at least one of a titanium oxide, a zinc oxide, a tin oxide and an indium oxide as a transparent semiconductor or semiconductors and comprises a donor-forming dopant material for donor formation in the transparent semiconductor or semiconductors.

4. The process for manufacturing a heterojunction solar cell (31) according to any one of claims 1 to 3, wherein the electroconductive adhesive (15) comprises at least one of a silicone resin, an epoxy resin, an acrylic resin, an alicyclic acrylic resin, a liquid crystal polymer, a polycarbonate and a polyethylene terephthalate.

5. The process for manufacturing a heterojunction solar cell (31) according to any one of claims 1 to 4, wherein a depth from the ion-implanted surface(13) to the ion implanted layer (14) is from 2 µm to 50 µm.

6. The process for manufacturing a heterojunction solar cell (31) according to any one of claims 1 to 5, wherein the transparent protective film (27) has a light-scattering property.

7. A heterojunction solar cell (31) comprising at least a metal substrate (12), an electroconductive adhesion layer (16), an n-type single-crystal silicon layer (17), an n-type transparent semiconductor layer (18) and a transparent protective film (27) in this order, and further comprising a collecting electrode (23) partially formed on a surface of the n-type transparent semiconductor layer (18) between the n-type transparent layer and the transparent protective film (27),
wherein the electroconductive adhesion layer (16) comprises transparent, electroconductive material, and comprises light scattering particles having a high refractive index or has microscopic voids having a size of about 0.1 µm or more for light scattering; and
wherein a material of the light scattering particles having a high refractive index is selected from the group consisting of a molybdenum oxide, and a hafnium oxide.

8. The heterojunction solar cell (31) according to claim 7, wherein the metal substrate (12) comprises at least one of aluminum, titanium, tungsten, chromium and nickel.

9. The heterojunction solar cell (31) according to claim 7 or 8, wherein the n-type transparent semiconductor layer (18) comprises at least one of a titanium oxide, a zinc oxide, a tin oxide and an indium oxide as a transparent semiconductor or semiconductors and comprises a donor-forming dopant material for donor formation in the transparent semiconductor or semiconductors.

10. The heterojunction solar cell (31) according to any one of claims 7 to 9, wherein the electroconductive adhesion layer (16) comprises at least one of a silicone resin, an epoxy resin, an acrylic resin, an alicyclic acrylic resin, a liquid crystal polymer, a polycarbonate and a polyethylene terephthalate.

11. The heterojunction solar cell (31) according to any one of claims 7 to 10, wherein the n-type single-crystal silicon layer (17) has a thickness of from 2 µm to 50 µm.

12. The heterojunction solar cell (31) according to any one of claims 7 to 11, wherein the transparent protective film (27) has a light-scattering property.

## Patentansprüche

1. Verfahren zur Herstellung einer Heteroübergang-Solarzelle (31) umfassend einen Schichtstoff umfassend wenigstens ein Metallsubstrat (12), eine n-Typ Silizium-Einkristall-Schicht (17), eine n-Typ transparente Halbleiterschicht (18) und einen transparenten Schutzfilm (27), eine Oberfläche des transparenten Schutzfilms (27), die als Licht empfangende Oberfläche dient, wobei das Verfahren die folgenden Schritte umfasst:
- Bereitstellen des Metallsubstrats (12) und des n-Typ Silizium-Einkristall-Substrats (11);
- Einbringen mindestens eines von einem Wasserstoffion und einem Edelgasion in das n-Typ Silizium-Einkristall-Substrat (11), um eine ionenimplantierte Schicht (14) zu bilden;
- Aufkleben einer ionenimplantierten Oberfläche (13) des n-Typ Silizium-Einkristall-Substrats (11) auf das Metallsubstrat (12) mittels eines elektrisch leitenden Klebstoffes (15);
- Aushärten des elektrisch leitenden Klebstoffes (15), um eine elektrisch leitfähige Adhäsionsschicht (16) zu bilden, so dass das n-Typ Silizium-Einkristall-Substrat (11) und das Metallsubstrat (12) zusammenlaminiert werden können;
- Aufbringen eines Stoßes auf die ionenimplantierte Schicht (14) zum mechanischen und teilweisen Delaminieren des n-Typ Silizium-Einkristall-Substrates (11), so dass eine n-Typ Silizium-Einkristall-Schicht (17) auf dem Metallsubstrat (12) verbleibt;
- Auftragen einer n-Typ transparenten Halbleiterschicht auf die n-Typ Silizium-Einkristall-Schicht (17);
- Bilden einer Sammelelektrode (23) auf einem Teil der n-Typ transparenten Halbleiterschicht (18);
- Bilden eines transparenten Schutzfilms (27) sowohl auf der n-Typ transparenten Halbleiterschicht (18) als auch auf der Sammelelektrode (23); und, wobei die elektrisch leitfähige Adhäsionsschicht (16) transparentes, elektrisch leitfähiges Material umfasst und Licht streuende Partikel mit einem hohen Brechungsindex umfasst, oder mikroskopische Poren mit einer Größe von 0,1 µm oder mehr zur Lichtbrechung aufweist; und
wobei ein Material der Licht streuenden Partikel mit einem hohen Brechungsindex ausgewählt ist aus der Gruppe bestehend aus Molybdänoxid und Hafniumoxid.

2. Verfahren zur Herstellung einer Heteroübergang-Solarzelle (31) gemäß Anspruch 1, wobei das Metallsubstrat (12) wenigstens eines von Aluminium, Titan, Wolfram, Chrom und Nickel umfasst.

3. Verfahren zur Herstellung einer Heteroübergang-Solarzelle (31) gemäß Anspruch 1 oder 2, wobei die n-Typ transparente Halbleiterschicht (18) wenigstens eines von Titanoxid, Zinkoxid, Zinnoxid und Indiumoxid als transparente(n) Halbleiter umfasst und einen Dotierungsstoff umfasst, der einen Donator bildet, zur Bildung eines Donators in dem/den transparenten Halbleiter(n).

4. Verfahren zur Herstellung einer Heteroübergang-Solarzelle (31) gemäß einem der Ansprüche 1 bis 3, wobei der elektrisch leitende Klebstoff (15) wenigstens eines von einem Silikonharz, einem Epoxidharz, einem Acrylharz, einem alizyklischem Acrylharz, einem Flüssigkristallpolymer, einem Polycarbonat und einem Polyethylenterephtalat umfasst.

5. Verfahren zur Herstellung einer Heteroübergang-Solarzelle (31) gemäß einem der Ansprüche 1 bis 4, wobei eine Tiefe von der ionenimplantierten Oberfläche (13) zur ionenimplantierten Schicht (14) von 2 µm bis 50 µm besteht.

6. Verfahren zur Herstellung einer Heteroübergang-Solarzelle (31) gemäß einem der Ansprüche 1 bis 5, wobei der transparente Schutzfilm (27) Licht streuende Eigenschaft aufweist.

7. Heteroübergang-Solarzelle (31) umfassend wenigstens ein Metallsubstrat (12), eine elektrisch leitfähige Adhäsionsschicht (16), eine n-Typ Silizium-Einkristall-Schicht (17), eine n-Typ transparente Halbleiterschicht (18) und einem transparenten Schutzfilm (27) in dieser Reihenfolge und weiter umfassend eine Sammelelektrode (23), die teilweise auf einer Oberfläche der n-Typ transparenten Halbleiterschicht (18) gebildet wurde, zwischen der n-Typ transparenten Schicht und dem transparenten Schutzfilm (27),
wobei die elektrisch leitfähige Adhäsionsschicht (16) transparentes, elektrisch leitfähiges Material umfasst und Licht streuende Partikel mit einem hohen Brechungsindex umfasst oder mikroskopische Poren mit einer Größe von 0,1 µm oder mehr zur Lichtbrechung aufweist; und
wobei ein Material der Licht streuenden Partikel mit einem hohen Brechungsindex ausgewählt ist aus der Gruppe bestehend aus Molybdänoxid und Hafniumoxid

8. Heteroübergang-Solarzelle (31) gemäß Anspruch 7, wobei das Metallsubtrat (12) wenigstens eines von Aluminium, Titan, Wolfram, Chrom und Nickel umfasst.

9. Heteroübergang-Solarzelle (31) gemäß Anspruch 7 oder 8, wobei die n-Typ transparente Halbleiterschicht (18) wenigstens eines von Titanoxid, Zinkoxid, Zinnoxid und Indiumoxid als transparente(n) Halbleiter umfasst und einen Dotierungsstoff umfasst, der einen Donator bildet, zur Bildung eines Donators in dem/den transparenten Halbleiter(n).

10. Heteroübergang-Solarzelle (31) gemäß einem der Ansprüche 7 bis 9, wobei die elektrisch leitfähige Adhäsionsschicht (16) wenigstens eines von einem Silikonharz, einem Epoxidharz, einem Acrylharz, einem alizyklischem Acrylharz, einem Flüssigkristallpolymer, einem Polycarbonat und einem Polyethylenterephtalat umfasst.

11. Heteroübergang-Solarzelle (31) gemäß einem der Ansprüche 7 bis 10, wobei die n-Typ Silizium-Einkristall-Schicht (17) eine Dicke von 2 µm bis 50 µm aufweist.

12. Heteroübergang-Solarzelle (31) gemäß einem der Ansprüche 7 bis 11, wobei der transparente Schutzfilm (27) Licht streuende Eigenschaft aufweist.

## Revendications

1. Procédé de fabrication d'une pile solaire à hétérojonction (31) comprenant un stratifié comprenant au moins un substrat en métal (12), une couche de silicium monocristallin de type n (17), une couche semiconductrice transparente de type n (18) et un film protecteur transparent (27), une surface du film protecteur transparent (27) servant de surface de réception de lumière, et le procédé comprenant les étapes de :
fourniture du substrat en métal (12) et du substrat en silicium monocristallin de type n (11) ;
implantation d'au moins l'un d'un ion hydrogène et d'un ion de gaz noble dans le substrat en silicium monocristallin de type n (11), de façon à former une couche à implantation ionique (14) ;
adhérence d'une surface à implantation ionique (13) du substrat en silicium monocristallin de type n (11) sur le substrat en métal (12) via un adhésif électroconducteur (15) ;
durcissement de l'adhésif électroconducteur (15), pour former une couche d'adhérence électroconductrice (16), de sorte que le substrat en silicium monocristallin de type n (11) et le substrat en métal (12) puissent se stratifier ensemble ;
transmission d'un impact à la couche à implantation ionique (14) pour déstratifier mécaniquement et partiellement le substrat en silicium monocristallin de type n (11), de façon à laisser une couche en silicium monocristallin de type n (17) sur le substrat en métal (12) ;
dépôt d'une couche semiconductrice transparente de type n sur la couche en silicium monocristallin de type n (17) ;
formation d'une électrode collectrice (23) sur une partie de la couche semiconductrice transparente de type n (18) ;
formation d'un film protecteur transparent (27) à la fois sur la couche de semiconducteur transparente de type n (18) et l'électrode collectrice (23) ; et,
dans lequel la couche d'adhérence électroconductrice (16) comprend un matériau électroconducteur transparent, et comprend des particules de diffusion de la lumière ayant un indice de réfraction élevé ou comporte des vides microscopiques ayant une taille d'environ 0,1 µm ou plus pour la diffusion de la lumière ; et
dans lequel un matériau des particules de diffusion de la lumière ayant un indice de réfraction élevé est choisi dans le groupe constitué d'un oxyde de molybdène et d'un oxyde de hafnium.

2. Procédé de fabrication d'une pile solaire à hétérojonction (13) selon la revendication 1, dans lequel le substrat en métal (12) comprend au moins l'un parmi l'aluminium, le titane, le tungstène, le chrome et le nickel.

3. Procédé de fabrication d'une pile solaire à hétérojonction (31) selon la revendication 1 ou 2, dans lequel la couche semiconductrice transparente de type n (18) comprend au moins l'un parmi un oxyde de titane, un oxyde de zinc, un oxyde d'étain et un oxyde d'indium en tant que semiconducteur(s) transparent(s) et comprend un matériau dopant de formation de donneur pour une formation de donneur dans le ou les semiconducteur(s) transparent(s).

4. Procédé de fabrication d'une pile solaire à hétérojonction (31) selon l'une quelconque des revendications 1 à 3, dans lequel l'adhésif électroconducteur (15) comprend au moins l'un parmi une résine de silicone, une résine époxy, une résine acrylique, une résine acrylique alicyclique, un polymère à cristal liquide, un polycarbonate et un polytéréphtalate d'éthylène.

5. Procédé de fabrication d'une pile solaire à hétérojonction (31) selon l'une quelconque des revendications 1 à 4, dans lequel une profondeur depuis la surface à implantation ionique (13) jusqu'à la couche à implantation ionique (14) est de 2 µm à 50 µm.

6. Procédé de fabrication d'une pile solaire à hétérojonction (31) selon l'une quelconque des revendications 1 à 5, dans lequel le film protecteur transparent (27) a une propriété de diffusion de la lumière.

7. Pile solaire à hétérojonction (31) comprenant au moins un substrat en métal (12), une couche d'adhérence électroconductrice (16), une couche de silicium monocristallin de type n (17), une couche semiconductrice transparente de type n (18) et un film protecteur transparent (27) dans cet ordre, et comprenant en outre une électrode collectrice (23) formée partiellement sur une surface de la couche semiconductrice transparente de type n (18) entre la couche transparente de type n et le film protecteur transparent (27),
dans laquelle la couche d'adhérence électroconductrice (16) comprend un matériau électroconducteur transparent, et comprend des particules de diffusion de la lumière ayant un indice de réfraction élevé ou comporte des vides microscopiques ayant une taille d'environ 0,1 µm ou plus pour la diffusion de la lumière ; et
dans laquelle un matériau des particules de diffusion de la lumière ayant un indice de réfraction élevé est choisi dans le groupe constitué d'un oxyde de molybdène et d'un oxyde de hafnium.

8. Pile solaire à hétérojonction (31) selon la revendication 7, dans laquelle le substrat en métal (12) comprend au moins l'un parmi l'aluminium, le titane, le tungstène, le chrome et le nickel.

9. Pile solaire à hétérojonction (31) selon la revendication 7 ou 8, dans laquelle la couche semiconductrice transparente de type n (18) comprend au moins l'un parmi un oxyde de titane, un oxyde de zinc, un oxyde d'étain et un oxyde d'indium en tant que semiconducteur(s) transparent(s) et comprend un matériau dopant de formation de donneur pour une formation de donneur dans le ou les semi-conducteur(s) transparent(s).

10. Pile solaire à hétérojonction (31) selon l'une quelconque des revendications 7 à 9, dans laquelle la couche d'adhérence électroconductrice (16) comprend au moins l'une parmi une résine de silicone, une résine époxy, une résine acrylique, une résine acrylique alicyclique, un polymère à cristal liquide, un polycarbonate et un polytéréphtalate d'éthylène.

11. Pile solaire à hétérojonction (31) selon l'une quelconque des revendications 7 à 10, dans laquelle la couche de silicium monocristallin de type n (17) a une épaisseur de 2 µm à 50 µm.

12. Pile solaire à hétérojonction (31) selon l'une quelconque des revendications 7 à 11, dans laquelle le film protecteur transparent (27) a une propriété de diffusion de la lumière.
